# EUROPEAN PATENT APPLICATION

(11) **EP 4 273 576 A1**
(43) Date of publication of application: **08.11.2023**
(21) Application number: 21914184.3
(22) Date of filing: 24.12.2021
(51) Int. Cl.: G01S 7/4863, H01L 27/146

(54) **SENSING UNIT FOR USE IN TIME-OF-FLIGHT IMAGE SENSOR AND DEMODULATION METHOD THEREOF**

(30) Priority: 31.12.2020 CN 202011637781; 31.12.2020 CN 202011637799
(71) Applicant: WUHAN JUXIN MICRO-ELECTRONICS CO., LTD., Wuhan, Hubei 430075 (CN)
(72) Inventor: QUAN, Rui, Wuhan, Hubei 430075 (CN); ZOU, Renting, Wuhan, Hubei 430075 (CN); WANG, Yifei, Wuhan, Hubei 430075 (CN); KONG, Fanxiao, Wuhan, Hubei 430075 (CN)
(74) Representative: Eisenführ Speiser
(86) International application number: PCT/CN2021/141137
(87) International publication number: WO 2022/143447

(57) **Abstract**

A sensing unit (100) for use in a time-of-flight image sensor and a demodulation method thereof. The sensing unit (100) for a time-of-flight image sensor may comprise: a first photosensitive region (102) comprising a pinned photodiode structure formed in a substrate (101) to generate photo-generated charges, the substrate (101) having a first doping type, the pinned photodiode comprising a first region having a second doping type and a second region located above the first region and having the first doping type; a first demodulation gate (103) used for transferring photo-generated charges in the first photosensitive region (102) to a first charge storage region (106); a second demodulation gate (104) used for transferring the photo-generated charges in the first photosensitive region (102) to a second charge storage region (108); a first transfer gate (109) used for transferring the photo-generated charges in the first charge storage region (106) to a first floating diffusion region (110); and a second transfer gate (111) used for transferring the photo-generated charges in the second charge storage region (108) to a second floating diffusion region (112).

## Description

### TECHNICAL FIELD OF THE DISCLOSURE

This application relates to the field of image sensing technology, and in particular to a sensing unit for a time-of-flight image sensor and a demodulation method for the sensing unit.

### BACKGROUND

A time-of-flight (ToF) image sensor is a type of sensor that may obtain image depth information, and record the position and motion status of people or objects in space. The time-of-flight image sensor actively emits a modulated optical signal and receives the reflected light generated by the optical signal acting on the object. The pixel unit on the time-of-flight image sensor may demodulate the reflected light, calculate the distance between the object and the sensor based on the phase difference between the emitted light signal and the reflected light signal, and further obtain the three-dimensional imaging of the object. Compared with 3D imaging technologies such as laser ranging and scanning, structured light and stereo vision, the time-of-flight image sensor has the advantages of high remote imaging accuracy, low computational complexity and less interference from ambient light. A depth camera based on time-of-flight image sensors may be widely used in fields such as autopilot, man-machine interaction, and medical scanning.

In the pixel unit of the time-of-flight image sensor, the light signal mainly acts on the photosensitive region. In order to improve the sensitivity of the time-of-flight image sensor, it is necessary to increase the area of the photosensitive region in the image sensor, namely the fill factor. In addition, how to achieve consistency in the readout circuit and image readout in physical pixel binning mode are problems that need to be solved when further optimizing the performance parameters of the time-of-flight image sensor.

On the other hand, the accuracy of the time-of-flight image sensor is mainly determined by the demodulation contrast of the demodulation pixel unit. In order to enhance the imaging clarity of time-of-flight image sensors, it is necessary to improve the transfer speed and demodulation accuracy of photo-generated electrons; especially for time-of-flight image sensors that use global exposure, improving the transfer speed of photo-generated electrons is the key to improving image quality.

### SUMMARY

To address the above and other issues, this application is submitted.

An aspect of the present application provides a sensing unit for a time-of-flight image sensor, which may comprise: a first photosensitive region, comprising a pinned photodiode structure formed in a substrate to generate photo-generated charges, the substrate having a first doping type, the pinned photodiode structure comprising a first region having a second doping type and a second region being located above the first region and having the first doping type; a first demodulation gate for transferring photo-generated charges in the first photosensitive region to a first charge storage region; a second demodulation gate for transferring photo-generated charges in the first photosensitive region to a second charge storage region; a first transfer gate for transferring photo-generated charges in the first charge storage region to a first floating diffusion region; and a second transfer gate for transferring photo-generated charges in the second charge storage region to a second floating diffusion region.

In some embodiments, the sensing unit may further comprise: a first storage gate located above the first charge storage region for facilitating the transfer of photo-generated charges from the first photosensitive region to the first charge storage region; and a second storage gate located above the second charge storage region for facilitating the transfer of photo-generated charges from the first photosensitive region to the second charge storage region.

In some embodiments, the first demodulation gate is partially or entirely located above the first photosensitive region, and the first demodulation gate and the first storage gate are simultaneously applied with voltages to transfer photo-generated charges from the first photosensitive region to the first charge storage region. The second demodulation gate is partially or entirely located above the first photosensitive region, and the second demodulation gate and the second storage gate are simultaneously applied with voltages to transfer photo-generated charges from the first photosensitive region to the second charge storage region.

In some embodiments, a voltage applied on the first demodulation gate is less than a voltage applied on the first storage gate, and a voltage applied on the second demodulation gate is less than a voltage applied on the second storage gate.

In some embodiments, a portion of the substrate covered by the first demodulation gate protrudes into the first photosensitive region, such that the first photosensitive region at least partially surrounds the portion of the substrate covered by the first demodulation gate. A portion of the substrate covered by the second demodulation gate protrudes into the first photosensitive region, such that the first photosensitive region at least partially surrounds the portion of the substrate covered by the second demodulation gate.

In some embodiments, the first demodulation gate and the second demodulation gate are located on opposite sides, adjacent sides, diagonal sides, or a same side of the first photosensitive region.

In some embodiments, the first demodulation gate and the second demodulation gate are rectangular, semicircular, semi regular polygon, fan-shaped, L-shaped or V-shaped.

In some embodiments, the sensing unit further comprises an intermediate demodulation gate located above the first photosensitive region and between the first demodulation gate and the second demodulation gate.

In some embodiments, when transferring photo-generated charges in the first photosensitive region to the first charge storage region, a voltage applied on the intermediate demodulation gate is less than a voltage applied on the first demodulation gate. When transferring the photo-generated charge in the first photosensitive region to the second charge storage region, a voltage applied on the intermediate demodulation gate is less than a voltage applied on the second demodulation gate.

In some embodiments, the intermediate demodulation gate has an H-shape, and the first and second demodulation gates are embedded in concave regions on opposite sides of the H shape, such that the intermediate demodulation gate surrounds a portion of the first and second demodulation gates.

In some embodiments, the first demodulation gate extends to above the first charge storage region, and the second demodulation gate extends to above the second charge storage region.

In some embodiments, a doping concentration in the second region of the pinned photodiode structure is higher than that of the substrate.

In some embodiments, the sensing unit further comprises: a second photosensitive region having the pinned photodiode structure so as to generate photo-generated charges; a third demodulation gate for transferring photo-generated charges in the second photosensitive region to a third charge storage region; a fourth demodulation gate for transferring photo-generated charges in the second photosensitive region to a fourth charge storage region; a third transfer gate for transferring photo-generated charges in the third charge storage region to the first floating diffusion region; and a fourth transfer gate for transferring photo-generated charges in the fourth charge storage region to the second floating diffusion region.

In some embodiments, the sensing unit further comprises: a third photosensitive region having the pinned photodiode structure so as to generate photo-generated charges; a fifth demodulation gate for transferring photo-generated charges in the third photosensitive region to a fifth charge storage region; a sixth demodulation gate for transferring photo-generated charges in the third photosensitive region to a sixth charge storage region; a fifth transfer gate for transferring photo-generated charges in the fifth charge storage region to the second floating diffusion region; a sixth transfer gate for transferring photo-generated charges in the sixth charge storage region to a third floating diffusion region; a fourth photosensitive region having the pinned photodiode structure so as to generate photo-generated charges; a seventh demodulation gate for transferring photo-generated charges in the fourth photosensitive region to a seventh charge storage region; an eighth demodulation gate for transferring photo-generated charges in the fourth photosensitive region to an eighth charge storage region; a seventh transfer gate for transferring photo-generated charges in the seventh charge storage region to the second floating diffusion region; and an eighth transfer gate for transferring photo-generated charges in the eighth charge storage region to the third floating diffusion region.

In some embodiments, the sensing unit further comprises: a first storage gate located above the first charge storage region for facilitating the transfer of photo-generated charges from the first photosensitive region to the first charge storage region; a second storage gate located above the second charge storage region for facilitating the transfer of photo-generated charges from the first photosensitive region to the second charge storage region; a third storage gate located above the third charge storage region for facilitating the transfer of photo-generated charges from the second photosensitive region to the third charge storage region; a fourth storage gate located above the fourth charge storage region for facilitating the transfer of photo-generated charges from the second photosensitive region to the fourth charge storage region; a fifth storage gate located above the fifth charge storage region for facilitating the transfer of photo-generated charges from the third photosensitive region to the fifth charge storage region; a sixth storage gate located above the sixth charge storage region for facilitating the transfer of photo-generated charges from the third photosensitive region to the sixth charge storage region; a seventh storage gate located above the seventh charge storage region for facilitating the transfer of photo-generated charges from the fourth photosensitive region to the seventh charge storage region; and an eighth storage gate, located above the eighth charge storage region for facilitating the transfer of photo-generated charges from the fourth photosensitive region to the eighth charge storage region.

In some embodiments, the sensing unit further comprises: a first anti-blooming gate for transferring residual photo-generated charges in the first photosensitive region to a first power supply voltage terminal; a second anti-blooming gate for transferring residual photo-generated charges in the second photosensitive region to the first power supply voltage terminal; a third anti-blooming gate for transferring residual photo-generated charges in the third photosensitive region to a second power supply voltage terminal; and a fourth anti-blooming gate for transferring residual photo-generated charges in the fourth photosensitive region to the second power supply voltage terminal.

Another aspect of the present application provides a time-of-flight image sensor, comprising an array formed by multiple sensing units.

Another aspect of the present application provides a demodulation method for a sensing unit used in a time-of-flight image sensor, wherein the sensing unit comprises multiple photosensitive regions. The method comprises: transferring photo-generated charges in each photosensitive region to a first charge storage region and a second charge storage region corresponding to the photosensitive region in a time sequential manner respectively; reading photo-generated charges in multiple first charge storage regions corresponding to the multiple photosensitive regions through a single first floating diffusion region respectively; and reading photo-generated charges in multiple second charge storage regions corresponding to the multiple photosensitive regions through a single second floating diffusion region respectively.

In some embodiments, photo-generated charges from different photosensitive regions are synchronously transferred to the corresponding first floating diffusion region or second floating diffusion region and simultaneously read out.

In some embodiments, photo-generated charges from different photosensitive regions are separately transferred to the corresponding first or second floating diffusion regions and read out separately.

In some embodiments, the first floating diffusion regions in multiple sensing units are read simultaneously, and the second floating diffusion regions in multiple sensing units are read simultaneously, and a time for reading the first floating diffusion region is different from a time for reading the second floating diffusion region.

The embodiments of this application have achieved many beneficial technical effects. For example, by providing a charge storage region, a global shutter mode may be achieved to ensure the accuracy of demodulation. The use of Pinned Photodiode (PPD) structure in the photosensitive region may improve the absorption efficiency of blue light and reduce surface dark current. In addition, the demodulation gate may invade the photosensitive region to form a multi-directional electric field structure, and an intermediate demodulation gate may also be set to increase the potential gradient and the length of the edge field, which is more conducive to the rapid transfer of photo-generated electrons, thereby achieving higher demodulation contrast and image clarity. The sensing unit provided in the embodiment not only has an increased filling coefficient of the photosensitive region, but also may achieve two reading modes: row by row reading and pixel merging reading. By sharing the floating diffusion region among multiple photosensitive regions, pixel merging is achieved at the physical level, and the full well capacity (FWC) of a single floating diffusion region is further improved, thus achieving better reading uniformity.

The above and other features and advantages of this application will become apparent from the detailed description of exemplary embodiments in conjunction with the accompanying drawings below.

### BRIEF DESCRIPTION OF THE DRAWINGS

Figure 1 is a top view of the sensing unit in the time-of-flight image sensor according to an embodiment of the present application;
Figure 2 is a cross-sectional view of the sensing unit taken along line A-A in Figure 1;
Figure 3 is a timing diagram of a signal for operating a sensing unit according to an embodiment of the present application;
Figure 4 is a cross-sectional view of a sensing unit according to another embodiment of the present application;
Figure 5 is a cross-sectional view of a sensing unit according to another embodiment of the present application;
Figure 6 is a schematic diagram of the layout of the photosensitive region and the demodulation gate in the sensing unit according to another embodiment of the present application;
Figure 7 is a top view of a sensing unit according to another embodiment of the present application;
Figure 8 is a cross-sectional view of the sensing unit taken along line B-B in Figure 7;
Figure 9 is a timing diagram for operating the signal of the sensing unit shown in Figure 7 according to an embodiment of the present application;
Figure 10 is a schematic diagram of the layout of the photosensitive region and the demodulation gate in the sensing unit according to another embodiment of the present application;
Figure 11 is a schematic diagram of the layout of the photosensitive region and the demodulation gate in the sensing unit according to another embodiment of the present application;
Figure 12 is a schematic diagram of the layout of the photosensitive region and the demodulation gate in the sensing unit according to another embodiment of the present application;
Figure 13 is a top view of the sensing unit in the time-of-flight image sensor according to another embodiment of the present application;
Figure 14 is a circuit diagram used for the sensing unit shown in Figure 13;
Figure 15 is a top view of the sensing unit in the time-of-flight image sensor according to another embodiment of the present application; and
Figure 16 is a flowchart of a method for demodulating a sensing unit in a time-of-flight image sensor according to an embodiment of the present application.

### DETAILED DESCRIPTION

The following will provide a detailed explanation of exemplary embodiments in conjunction with the accompanying drawings, but this application is not limited to the exemplary embodiments described here.

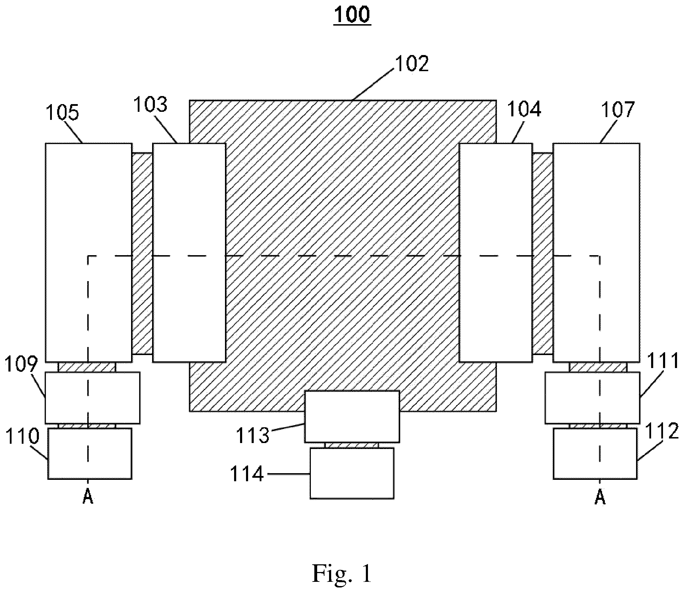

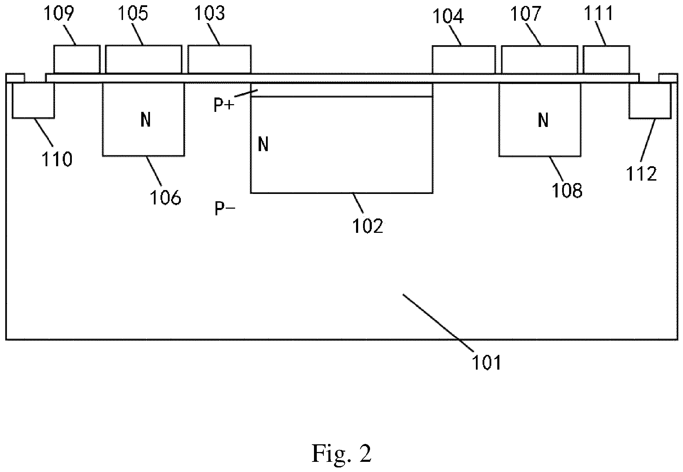

Figure 1 shows a top view of a sensing unit 100 in a Time-of-Flight (ToF) image sensor according to an embodiment of the present application, and Figure 2 shows a cross-sectional view of the sensing unit 100 taken along line A-A in Figure 1. In the embodiments shown in Figures 1 and 2, the sensing unit 100 comprises a single pixel, so the sensing unit 100 may also be referred to as a pixel unit 100. However, it shall be understood that in some embodiments, one sensing unit may also comprise multiple pixel units.

Referring to Figures 1 and 2, the sensing unit 100 may comprise a P-type substrate 101 with a first doping concentration, a photosensitive region 102, a first demodulation gate 103, a second demodulation gate 104, a first storage gate 105, a first charge storage region 106, a second storage gate 107, and a second charge storage region 108. The substrate 101 may be a P-type doped silicon substrate, and the gate insulation layer, such as a silica layer, may be located between the substrate 101 and each gate. In some embodiments, the photosensitive region 102 may adopt a pinned photodiode (PPD) structure, comprising an N-type doped first region and a P-type doped second region located above the first region. The doping concentration in the second region is higher than that of the P-type substrate 101. The PPD structure separates the charge collection region from the interface of the silicon substrate/silica gate insulation layer, and accomplishes the charge collection through P+/N junctions and N/P- junctions, avoiding the adverse effects of fixed charges in the interface state and silica layer, improving the absorption efficiency of blue light, and reducing surface dark current. The first charge storage region 106 and the second charge storage region 108 are both formed by N wells with N-type doping, located on opposite sides of the photosensitive region 102, and spaced apart at an appropriate distance from the photosensitive region 102. In the embodiment shown in Figure 2, the first demodulation gate 103 is located above the substrate region between the photosensitive region 102 and the first charge storage region 106, and the second demodulation gate 104 is located above the substrate region between the photosensitive region 102 and the second charge storage region 108. The first storage gate 105 is located above the first charge storage region 106, and the second storage gate 107 is located above the second charge storage region 108. The first charge storage region 106 and the second charge storage region 108 may store photo-generated electrons generated in the photosensitive region 102, enabling the photo-generated electrons generated in the photosensitive region 102 after global exposure to be quickly demodulated to regions outside the photosensitive region 102, while avoiding generating a large amount of noisy electrons due to the storage of photo-generated electrons in the floating diffusion region (described below). For the convenience of description, the doping types of the relevant layers and regions are explained herein using P-type and N-type as examples. However, it shall be understood that the embodiments of this application are not limited to these examples, but may also use opposite doping types, for example.

Taking the transfer of photo-generated electrons to the first charge storage region 106 as an example, the process of demodulating the reflected light signal will be explained below. When reflected light irradiates on the photosensitive region 102, photo-generated electrons are collected in the PPD structure. At this point, a high bias voltage is applied to the first demodulation gate 103 and the first storage gate 105, and a low bias voltage is applied to the second demodulation gate 104. The photo-generated electrons are transferred from the photosensitive region 102 to the first charge storage region 106, thereby completing the rapid transfer and storage of photo-generated electrons. By using this charge storage form, the global shutter (GS) structure of the time-of-flight image sensor has been implemented, allowing the entire image to be exposed and light signal to be collected at the same time, avoiding slope or shaking phenomena in the rolling shutter (RS) structure. Correspondingly, when it is required to transfer photo-generated electron to the second charge storage region 108, a low bias voltage is applied to the first demodulation gate 103, a high bias voltage is applied to the second demodulation gate 104 and the second storage gate 107, and thus photo-generated electrons are transferred from the photosensitive region 102 to the second charge storage region 108. Repeating the process for transferring photo-generated electron for several times, and thus the demodulation of photo-generated electrons is realized.

Specifically, the sensing unit 100 of the time-of-flight image sensor may further comprise a first transfer gate 109 and a first floating diffusion region 110 for transferring and reading photo-generated electrons in the first charge storage region 106, and a second transfer gate 111 and a second floating diffusion region 112 for transferring and reading photo-generated electrons in the second charge storage region 108. The first transfer gate 109 is located above the substrate region between the first charge storage region 106 and the first floating diffusion region 110, and the second transfer gate 111 is located above the substrate region between the second charge storage region 108 and the second floating diffusion region 112. The photo-generated electrons in charge storage regions 106 and 108 may be read out row by row using correlated double sampling through transfer gates 109, 111, and floating diffusion regions 110 and 112. In addition, the sensing unit 100 is also provided with an anti-blooming function, and an anti-blooming gate 113 may transfer the redundant photo-generated electrons in the photosensitive region 102 to the power supply voltage VDD terminal 114. When the light intensity is too strong, there are still residual electrons in the substrate after demodulation and they will be collected in the photosensitive region 102. At this time, the anti-blooming gate 113 is turned on to clear the electrons in the photosensitive region 102, avoiding interference with the next sampling period.

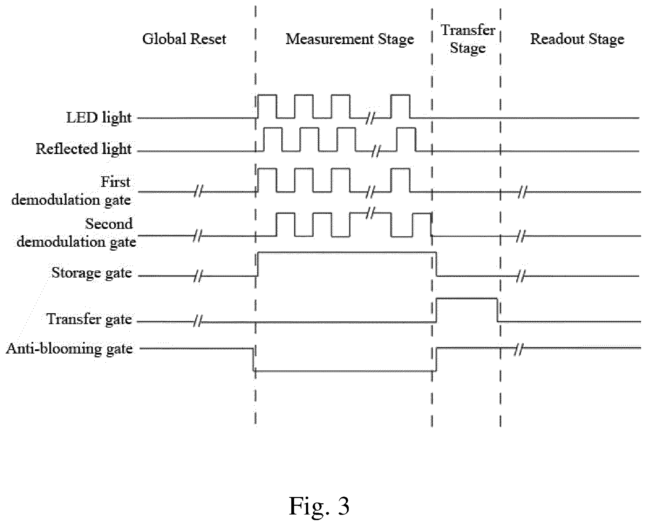

Figure 3 shows a timing diagram for operating a signal of the sensing unit 100 according to an embodiment of the present application. During the global reset stage, a high voltage may be applied to the anti-blooming gate 113 to electrically connect the photosensitive region 102 to the power supply voltage VDD terminal 114 to clear electrons in the photosensitive region 102. During the measurement stage, the LED light source emits a modulated optical signal, and the time-of-flight sensing unit 100 receives reflected light with a phase difference from the optical signal. A control signal with the same phase as the LED modulated light is applied to the first demodulation gate 103, and a control signal with the opposite phase as the LED modulated light is applied to the second demodulation gate 104. The first storage gate 105 and the second storage gate 107 remain at a high level, while the first transfer gate 109, the second transfer gate 111, and the anti-blooming gate 113 remain at a low level. Thus, the photo-generated electrons generated in the photosensitive region 102 are sequentially moved to the first charge storage region 106 and the second charge storage region 108. In the transfer stage, the first transfer gate 109, the second transfer gate 111, and the anti-blooming gate 113 are set to a high level, while the remaining gate signals are kept at a low level, such that electrons in the first and second charge storage regions 106 and 108 may be transferred to the floating diffusion regions 110 and 112, respectively, and residual photo-generated electrons in the photosensitive region 102 may be removed. During the readout stage, the anti-blooming gate 113 remains at a high level, while the remaining gate signals remain at a low level. Through the above steps, the time-of-flight detection of the pulse modulation wave method may be completed by using only two demodulation gates with opposite phases.

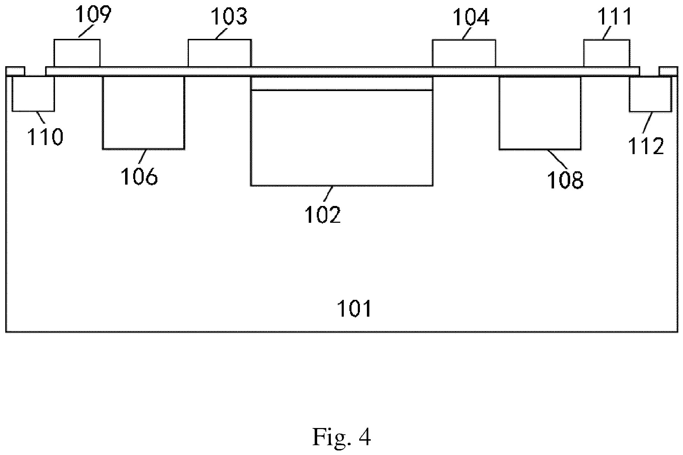

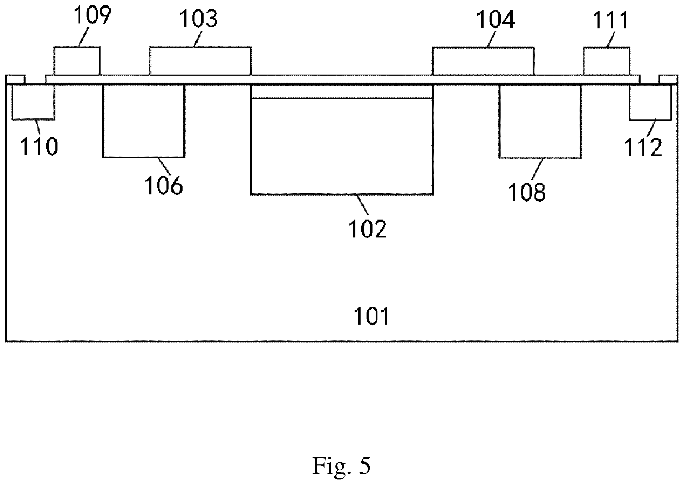

Figures 4 and 5 show cross-sectional views of the sensing unit 100 according to other embodiments of the present application. Compared with the embodiments shown in Figure 2, in the embodiments shown in Figures 4 and 5, the transfer of photo-generated electrons from the photosensitive region 102 to the charge storage regions 106 and 108 may be achieved by applying high bias voltage to the demodulation gates 103 and 104 alone without setting the storage gates 105 and 107. In the embodiment shown in Figure 4, the first demodulation gate 103 is only formed above the substrate region between the photosensitive region 102 and the first charge storage region 106, and the second demodulation gate 104 is only formed above the substrate region between the photosensitive region 102 and the second charge storage region 108. In the embodiment shown in Figure 5, the first demodulation gate 103 may also be partially extended to above the first charge storage region 106, and the second demodulation gate 104 may also be partially extended to above the second charge storage region 108.

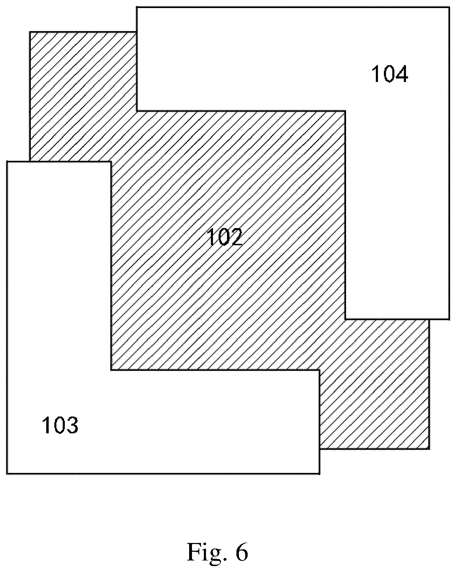

It shall be noted that the positions of the two demodulation gates 103 and 104 may be set not only on opposite sides of the photosensitive region 102 as shown in Figure 1, but also on the same side, diagonal opposite sides, or adjacent two sides of the photosensitive region 102. Shapes of the demodulation gate may be but are not limited to rectangle, semicircle, semi regular polygon, fan-shape, L-shape, V-shape, etc. As shown in Figure 6, the first demodulation gate 103 and the second demodulation gate 104 are both "L" shaped and located on opposite diagonals of the photosensitive region 102, respectively. This shape of demodulation gate may simultaneously provide a demodulation electric field for both edges of the photosensitive region 102, which is conducive to the rapid transfer of photo-generated electrons. In this embodiment, there may be or may not be a doped photosensitive region below the first demodulation gate 103 and the second demodulation gate 104.

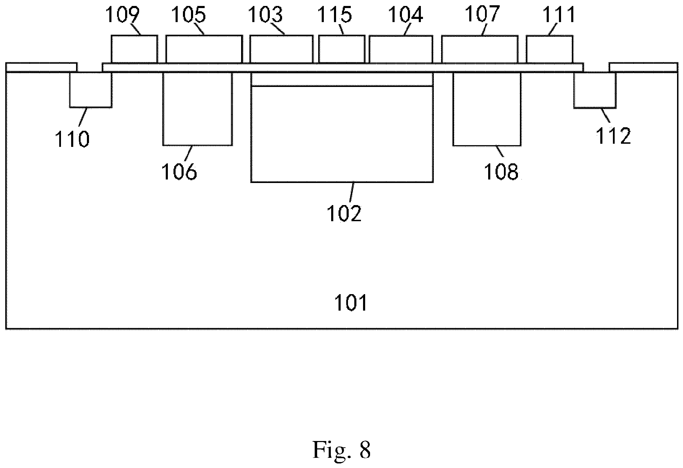

The above describes embodiments where the first demodulation gate 103 is only formed above the substrate region between the photosensitive region 102 and the first charge storage region 106, and the second demodulation gate 104 is only formed above the substrate region between the photosensitive region 102 and the second charge storage region 108. However, it shall be understood that the position of the demodulation gate is not limited to these embodiments. For example, in some embodiments, the first demodulation gate 103 may also be partially extended to above the photosensitive region 102, or even fully formed above the photosensitive region 102 as shown in Figure 8, such that in the top view, the first demodulation gate 103 may be partially surrounded by the photosensitive region 102. Similarly, the second demodulation gate 104 may also be partially extended to above the photosensitive region 102, or even fully formed above the photosensitive region 102 as shown in Figure 8, such that in the top view, the second demodulation gate 104 may be partially surrounded by the photosensitive region 102. In some embodiments, the substrate region covered by the first demodulation gate 103 as a non-photosensitive region may also protrude into the photosensitive region 102, allowing the photosensitive region 102 to partially surround the substrate region covered by the first demodulation gate 103 as a non-photosensitive region. The substrate region covered by the second demodulation gate 104 as a non-photosensitive region may also protrude into the photosensitive region 102, such that the photosensitive region 102 may partially surround the substrate region covered by the second demodulation gate 104 as a non-photosensitive region. The demodulation gate and the structure that the substrate region covered by the demodulation gate as the non-photosensitive region protrudes into the photosensitive region may increase the length of the edge electric field and form a multidirectional electric field structure, which is more conducive to transferring the photo-generated electron in the photosensitive region to the charge storage region.

The structure where the demodulation gate protrudes into the photosensitive region and overlaps with the photosensitive region can be obtained through the pre gate process, which involves doping the photosensitive region before forming the demodulation gate, and then forming a demodulation gate that overlaps at least partially with the photosensitive region. The structure where the demodulation gate protrudes into the photosensitive region but does not overlap with the photosensitive region can be obtained through pre gate or post gate processes. In the post gate process, after forming a demodulation gate, the region between two demodulation gates is doped to obtain a photosensitive region.

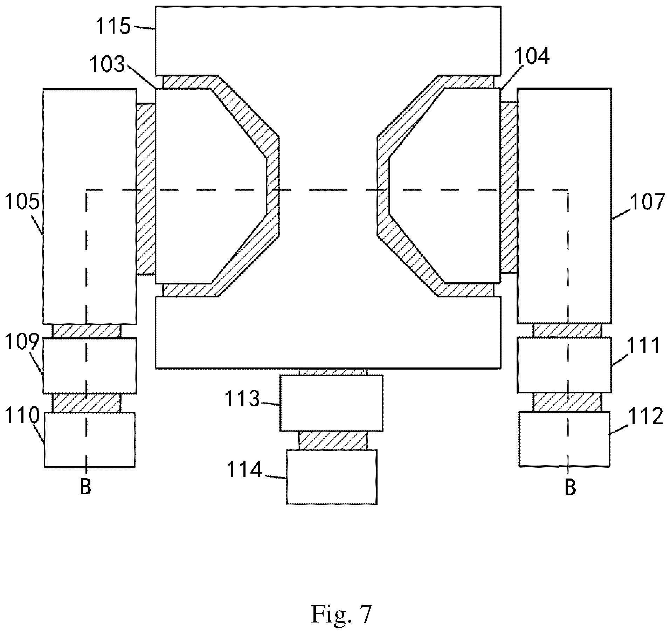

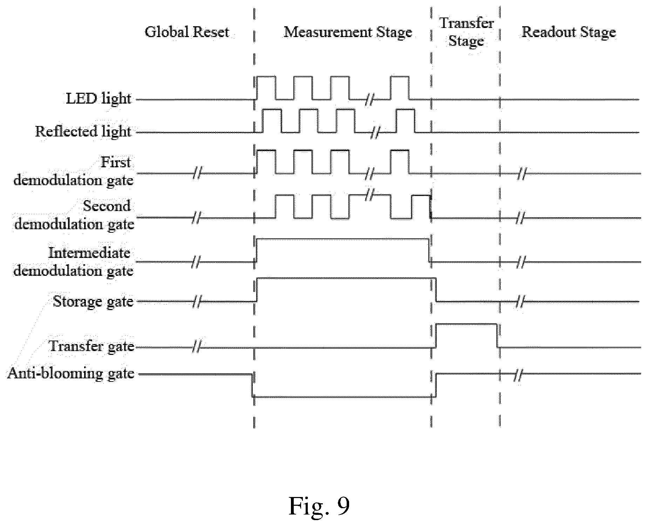

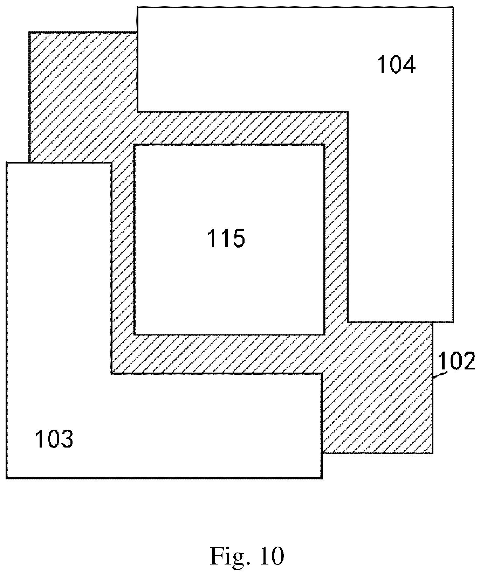

When two demodulation gates are used for demodulation, the edge electric field provided by them to promote electron drift motion may not be large enough, and most electrons diffuse under the gate, resulting in insufficient transfer speed of photo-generated electrons. In the embodiments shown in Figures 7 and 8, a structure with three demodulation gates is provided. In addition to the first demodulation gate 103 and the second demodulation gate 104, there is also an intermediate demodulation gate 115 arranged between the first demodulation gate 103 and the second demodulation gate 104. It shall be noted that in the embodiments shown in Figures 7 and 8, both the first demodulation gate 103 and the second demodulation gate 104 are located above the photosensitive region 102, while they are substantially not located above the substrate between the photosensitive region and the charge storage region. The storage gates 105 and 107 are respectively arranged above the charge storage regions 106 and 108, and partially extend above the substrate between the photosensitive region and the charge storage region. In the measurement stage, a voltage is alternately applied on the first demodulation gate 103 and the second demodulation gate 104, while a voltage is continuously applied on the intermediate demodulation gate 115, the first storage gate 105 and the second storage gate 107, so that the photo-generated electrons in the photosensitive region 102 are alternately transferred to the first charge storage region 106 and the second charge storage region 108. In some embodiments, the voltage applied on the intermediate demodulation gate 115 is lower than the voltage applied on the first demodulation gate 103 and the second demodulation gate 104, and the voltage applied on the first demodulation gate 103 and the second demodulation gate 104 is lower than the voltage applied on the first storage gate 105 and the second storage gate 107, forming a voltage gradient to facilitate the lateral transfer of photo-generated electrons. The three demodulation gates can be three immediate adjacent vertical bar gates, or they can be embedded structures where the demodulation gates on both sides protrude into the intermediate demodulation gate to form a multi-directional electric field. In addition, the number of intermediate demodulation gates can be further increased, thereby further increasing the gradient level to improve the transfer speed of photo-generated electrons. The embodiment shown in Figure 7 adopts an embedded multidirectional electric field structure, where the intermediate demodulation gate 115 is in an "H" shape, and the first demodulation gate 103 and the second demodulation gate 104 are embedded on both sides of the intermediate demodulation gate 115, so that the intermediate demodulation gate 115 partially surrounds the first demodulation gate 103 and the second demodulation gate 104. Compared to using three immediate adjacent vertical bar gates, the demodulation gates in the embedded multidirectional electric field structure can increase the length of the edge electric field, which is more conducive to charge transfer. Figure 9 shows the operation signal timing diagram for the sensing unit 100 shown in Figures 7 and 8. Compared to the signal timing diagram shown in Figure 3, a bias voltage needs to be continuously applied on the intermediate demodulation gate 115 during the measurement stage to increase the gradient level and increase the transfer speed of photo-generated electrons. Figure 10 shows another embodiment of a three demodulation gate structure, in which the shape and position of the modulation gates are changed.

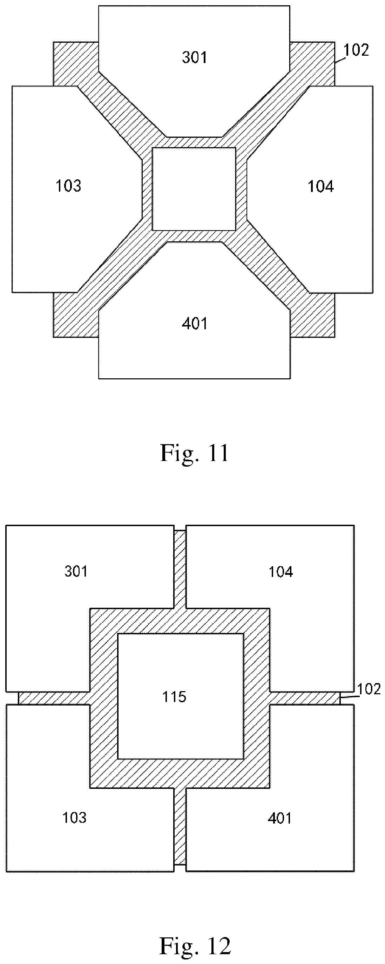

In another embodiment, the number of demodulation gates can be increased to four or more. For example, the number of intermediate demodulation gates can be further increased to accelerate the lateral transfer speed of photo-generated electrons by increasing the stage number of voltage gradients. In addition, the number of photosensitive regions and demodulation gates may be increased, so that a single pixel can be applied in continuous modulation wave methods. For example, by adding a third demodulation gate 301 and a fourth demodulation gate 401, four demodulation gates are used to collect photo-generated electron quantities in four windows with a 90° phase delay in sequence. The embodiments shown in Figures 11 and 12 both adopt a structure in which the intermediate demodulation gate 115 works in conjunction with the first demodulation gate 103, the second demodulation gate 104, the third demodulation gate 301, and the fourth demodulation gate 401, which can increase the transfer speed of photo-generated electrons in the continuous modulation wave method. In the embodiment shown in Figure 11, the first demodulation gate 103, the second demodulation gate 104, the third demodulation gate 301, and the fourth demodulation gate 401 are respectively arranged on the four sides of the intermediate demodulation gate 115; in the embodiment shown in Figure 12, the first demodulation gate 103, the second demodulation gate 104, the third demodulation gate 301, and the fourth demodulation gate 401 each have an L-shape and are arranged around the four corners of the intermediate demodulation gate 115, respectively.

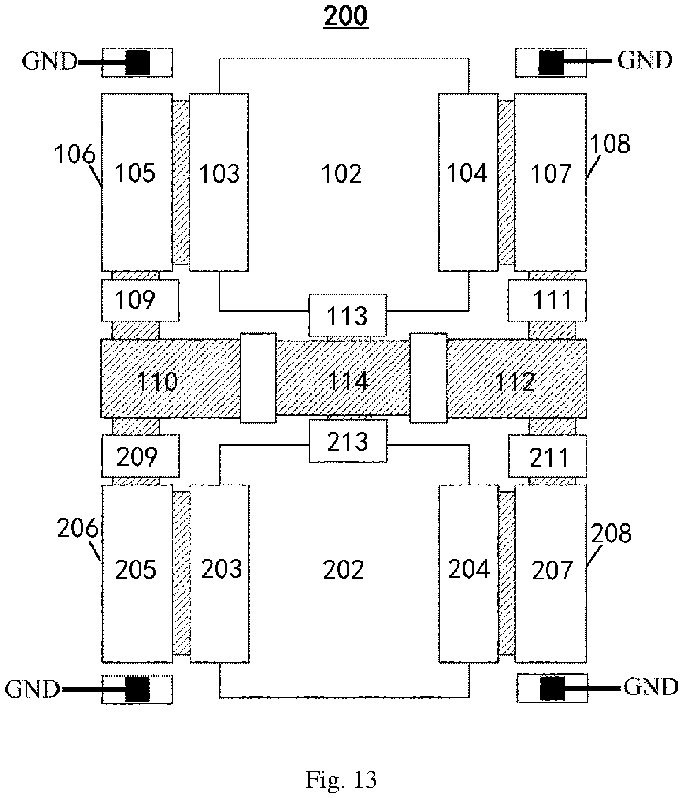

Figure 13 shows an embodiment of a sensing unit 200 comprising two pixels, wherein the structure of each pixel can be the same as the embodiment described above with reference to Figures 1-2, and the two pixels can share a floating diffusion region. As shown in Figure 13, the sensing unit 200 comprises a first photosensitive region 102 of the first pixel and a second photosensitive region 202 of the second pixel. The photosensitive regions 102 and 202 can adopt the structure of a pinned photodiode (PPD), including a first region of N-type doping and a second region of P-type doping formed in the P-type substrate 101 (see the cross-sectional view of Figure 2), with a doping concentration in the second region higher than that of the P-type substrate. The PPD structure separates the charge collection region from the interface of the silicon substrate/silica gate insulation layer, and completes the charge collection through P+/N junctions and N/P- junctions, avoiding the adverse effects of fixed charges in the interface state and silica layer, improving the absorption efficiency of blue light, and reducing surface dark current. The sensing unit 200 further comprises a first demodulation gate 103 and a second demodulation gate 104 arranged on both sides of the first photosensitive region 102, as well as a third demodulation gate 203 and a fourth demodulation gate 204 arranged on both sides of the second photosensitive region 202. The first demodulation gate 103 is used to transfer the photo-generated electrons in the first photosensitive region 102 to the first charge storage region 106 below the first storage gate 105, the second demodulation gate 104 is used to transfer the photo-generated electrons in the first photosensitive region 102 to the second charge storage region 108 below the second storage gate 107, the third demodulation gate 203 is used to transfer the photo-generated electrons in the second photosensitive region 202 to the third charge storage region 206 below the third storage gate 205, and the fourth demodulation gate 204 is used to transfer the photo-generated electrons in the second photosensitive region 202 to the fourth charge storage region 208 below the fourth storage gate 207. The photo-generated electrons stored in the first charge storage region 106 can be transferred to the first floating diffusion region 110 through the first transfer gate 109, and then read out by the reading circuit. The photo-generated electrons stored in the second charge storage region 108 can be transferred to the second floating diffusion region 112 through the second transfer gate 111, and then read out by the reading circuit. The second photosensitive region 202 can share the floating diffusion regions 110 and 112, as well as the reading circuit, with the first photosensitive region 102. Specifically, the photo-generated electrons stored in the third charge storage region 206 can be transferred to the first floating diffusion region 110 through the third transfer gate 209, and then read out by the reading circuit. The photo-generated electrons stored in the fourth charge storage region 208 can be transferred to the second floating diffusion region 112 through the fourth transfer gate 211, and then read out by the reading circuit. That is to say, the first floating diffusion region 110 is connected to the first photosensitive region 102 through the first charge storage region 106, and to the second photosensitive region 202 through the third charge storage region 206; the second floating diffusion region 112 is connected to the first photosensitive region 102 through the second charge storage region 108, and to the second photosensitive region 202 through the fourth charge storage region 208. Figure 13 shows the first storage gate 105, second storage gate 107, third storage gate 205, and fourth storage gate 207 formed above the first charge storage region 106, second charge storage region 108, third charge storage region 206, and fourth charge storage region 208, respectively, so as to accelerate the transfer speed of photo-generated electrons. However, in other embodiments, the first storage gate 105, the second storage gate 107, the third storage gate 205 and the fourth storage gate 207 can also be omitted (see Figure 4). When the first storage gate 105, the second storage gate 107, the third storage gate 205, and the fourth storage gate 207 are omitted, the first demodulation gate 103, second demodulation gate 104, third demodulation gate 203, and fourth demodulation gate 204 can extend above the first charge storage region 106, second charge storage region 108, third charge storage region 206, and fourth charge storage region 208, respectively (see Figure 5).

The sensing unit 200 is also provided with an anti-blooming function. The first anti blooming gate 113 can transfer the excess photo-generated electrons in the first photosensitive region 102 to the power supply voltage VDD terminal 114, and the second anti-blooming gate 213 can transfer the excess photo-generated electrons in the second photosensitive region 202 to the power supply voltage VDD terminal 114. When the light intensity is too strong, there are still residual electrons in the substrate after demodulation, which will be collected in the first photosensitive region 102 and the second photosensitive region 202. At this time, the anti-blooming gates 113 and 213 are turned on to clear the electrons in the photosensitive regions 102 and 202, avoiding interference with the next sampling period.

It can be seen that the sensing unit 200 shown in Figure 13 comprises two symmetrically arranged pixels, which share the first floating diffusion region 110, the power supply voltage VDD terminal 114, and the second floating diffusion region 112. The structure of each pixel can be the same as shown in Figures 1 and 2. In addition, the various embodiments described above with reference to Figures 3-12 can also be applied to the sensing unit 200, and the description thereof will not be repeated here.

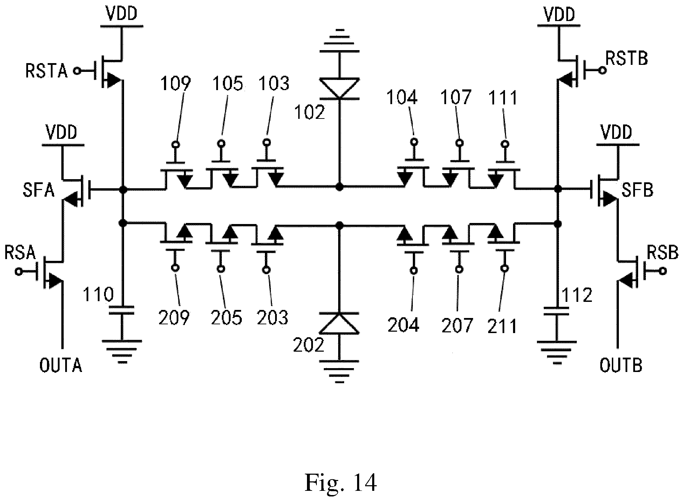

Figure 14 is a circuit schematic diagram of the time-of-flight sensing unit 200 in Figure 13, showing the shared floating diffusion regions 110, 112, and reading circuit between the first and second photosensitive regions 102 and 202. The photo-generated electrons generated in the first photosensitive region 102 can be transferred towards the first floating diffusion region 110 under the control of the first demodulation gate 103, the first storage gate 105, and the first transfer gate 109, or towards the second floating diffusion region 112 under the control of the second demodulation gate 104, the second storage gate 107, and the second transfer gate 111. The photo-generated electrons generated in the second photosensitive region 202 can be transferred towards the first floating diffusion region 110 under the control of the third demodulation gate 203, the third storage gate 205, and the third transfer gate 209, or towards the second floating diffusion region 112 under the control of the fourth demodulation gate 204, the fourth storage gate 207, and the fourth transfer gate 211. The photo-generated electrons in the first photosensitive region 102 and the photo-generated electrons in the second photosensitive region 202 can be transferred independently to the first floating diffusion region 110 or the second floating diffusion region 112, respectively, or simultaneously to the first floating diffusion region 110 or the second floating diffusion region 112. The transfer of photo-generated electrons in a single photosensitive region towards the floating diffusion region can be described as operated above with reference to Figure 3 or Figure 9, and will not be repeated here.

In order to read charges from the floating diffusion region, the first floating diffusion region 110 can be connected to the gate of a first source following transistor SFA. One end of the first source following transistor SFA is connected to the power supply voltage VDD, and the other end is connected to the first output terminal OUTA through a first row selection transistor RSA to provide the first output signal. The second floating diffusion region 112 can be connected to the gate of a second source following transistor SFB. One end of the second source following transistor SFB is connected to the power supply voltage VDD, and the other end is connected to the second output terminal OUTB through a second row selection transistor RSB to provide a second output signal.

The sensing unit 200 can operate in row by row reading mode or pixel merging reading mode based on the control signal. When the sensing unit 200 operates in a row by row reading mode, the reading circuit reads out the photo-generated electrons stored in each charge storage region row by row. When the reading circuit reads out the photo-generated electrons in the first charge storage region 106 through the first floating diffusion region 110, and reads out the photo-generated electrons in the second charge storage region 108 through the second floating diffusion region 112, the photo-generated electrons in the third charge storage region 206 and the fourth charge storage region 208 remain in the storage region and are not transferred to the floating diffusion region. When the reading circuit finishes reading the row where the first photosensitive region 102 is located and starts reading the row where the second photosensitive region 202 is located, the photo-generated electrons stored in the third charge storage region 206 and the fourth charge storage region 208 are transferred to the floating diffusion region and read by the reading circuit. When the sensing unit 200 operates in pixel merging reading mode, the reading circuit simultaneously reads out the photo-generated electrons stored in the upper and lower charge storage regions connected to the same floating diffusion region. The photo-generated electrons in the first charge storage region 106 and the third charge storage region 206 are simultaneously transferred to the first floating diffusion region 110, and read through a reading circuit; the photo-generated electrons in the second charge storage region 108 and the fourth charge storage region 208 are simultaneously transferred to the second floating diffusion region 112, and read through the reading circuit. By sharing the floating diffusion region and reading circuit between the upper and lower photosensitive regions, not only the pixel filling coefficient is increased, pixel merging is achieved at the physical level, but also the full well capacity (FWC) of a single floating diffusion region is further improved, achieving better uniformity and reducing non-consistency caused by process errors.

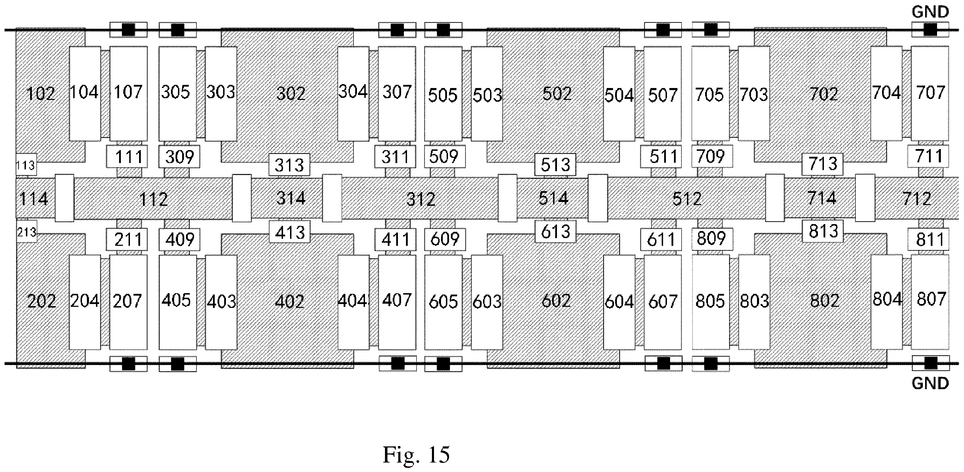

In the sensing unit of the time-of-flight image sensor, it is also possible to further increase the pixel filling coefficient by sharing the same floating diffusion region among more photosensitive regions. Figure 15 is a top view of multiple sensing units 200 in a time-of-flight image sensor according to another embodiment of the present application, wherein the multiple sensing units 200 are arranged side by side, so that four photosensitive regions can share the same floating diffusion region, and each photosensitive region has its own demodulation gate and charge storage region. Referring to Figure 15, the photo-generated charges in the first photosensitive region 102 can be transferred to the second floating diffusion region 112 under the control of the second demodulation gate 104, the second storage gate 107, and the second transfer gate 111. The photo-generated charges in the second photosensitive region 202 can be transferred to the second floating diffusion region 112 under the control of the fourth demodulation gate 204, the fourth storage gate 207, and the fourth transfer gate 211. The photo-generated charges in the third photosensitive region 302 can be transferred to the second floating diffusion region 112 under the control of the fifth demodulation gate 303, the fifth storage gate 305 and fifth transfer gate 309, and the photo-generated charges in the fourth photosensitive region 402 can be transferred to the second floating diffusion region 112 under the control of the seventh demodulation gate 403, the seventh storage gate 403, and the seventh transfer gate 409. In addition, the first photosensitive region 102 and the second photosensitive region 202 can share the first power supply voltage VDD terminal 114. The first anti-blooming gate 113 and the second anti-blooming gate 213 can transfer the excess photo-generated electrons in the first photosensitive region 102 and the second photosensitive region 202 to the first power supply voltage VDD terminal 114, respectively. The third photosensitive region 302 and the fourth photosensitive region 402 can share the second power supply voltage VDD terminal 314. The third anti-blooming gate 313 and the fourth anti-blooming gate 413 can transfer the excess photo-generated electrons in the third photosensitive region 302 and the fourth photosensitive region 402 to the second power supply voltage VDD terminal 314, respectively.

Similarly, the photo-generated charges in the third photosensitive region 302 can be transferred to the third floating diffusion region 312 under the control of the sixth demodulation gate 304, the sixth storage gate 307, and the sixth transfer gate 311. The photo-generated charges in the fourth photosensitive region 402 can be transferred to the third floating diffusion region 312 under the control of the eighth demodulation gate 404, the eighth storage gate 407, and the eighth transfer gate 411. The photo-generated charges in the fifth photosensitive region 502 can be transferred to the third floating diffusion region 312 under the control of the ninth demodulation gate 503, the ninth storage gate 505 and the ninth transfer gate 509, and the photo-generated charges in the sixth photosensitive region 602 can be transferred to the third floating diffusion region 312 under the control of the eleventh demodulation gate 603, the eleventh storage gate 605, and the eleventh transfer gate 609. The fifth photosensitive region 502 and the sixth photosensitive region 602 can share the third power supply voltage VDD terminal 514. The fifth anti-blooming gate 513 and the sixth anti-blooming gate 613 can transfer the excess photo-generated electrons in the fifth photosensitive region 502 and the sixth photosensitive region 602 to the third power supply voltage VDD terminal 514, respectively.

Similarly, the photo-generated charges in the fifth photosensitive region 502 can be transferred to the fourth floating diffusion region 512 under the control of the tenth demodulation gate 504, the tenth storage gate 507, and the tenth transfer gate 511. The photo-generated charges in the sixth photosensitive region 602 can be transferred to the fourth floating diffusion region 512 under the control of the twelfth demodulation gate 604, the twelfth storage gate 607, and the twelfth transfer gate 611. The photo-generated charges in the seventh photosensitive region 702 can be transferred to the fourth floating diffusion region 512 under the control of the thirteenth demodulation gate 703, the thirteenth storage gate 705, and the thirteenth transfer gate 709, and the photo-generated charges in the eighth photosensitive region 802 can be transferred to the fourth floating diffusion region 512 under the control of the fifteenth demodulation gate 803, the thirteenth storage gate 803, and the thirteenth transfer gate 809. The seventh photosensitive region 702 and the eighth photosensitive region 802 can share the fourth power supply voltage VDD terminal 714. The seventh anti-blooming gate 713 and the eighth anti-blooming gate 813 can transfer the excess photo-generated electrons in the seventh photosensitive region 702 and the eighth photosensitive region 802 to the fourth power supply voltage VDD terminal 714, respectively.

Similarly, the seventh photosensitive region 702 and the eighth photosensitive region 802 can also share the fifth floating diffusion region 712 with the next two photosensitive regions (not shown). The photo-generated charges in the seventh photosensitive region 702 can be transferred to the fifth floating diffusion region 712 under the control of the fourteenth demodulation gate 704, the fourteenth storage gate 707, and the fourteenth transfer gate 711, and the photo-generated charges in the eighth photosensitive region 802 can be transferred to the fifth floating diffusion region 712 under the control of the sixteenth demodulation gate 804, the sixteenth storage gate 807, and the sixteenth transfer gate 811.

In the embodiment shown in Figure 15, due to the shared floating diffusion region among multiple photosensitive regions, the sensing unit can not only operate in row by row reading mode and pixel merging reading mode, but also in more operating modes. For example, in the row by row reading mode, the photo-generated charges generated in the first photosensitive region 102 and the third photosensitive region 302 can be read from the second floating diffusion region 112, respectively. Then, when reading the next row, the photo-generated charges generated in the second photosensitive region 202 and the fourth photosensitive region 402 can be read from the second floating diffusion region 112, respectively. In the pixel merging reading mode, the photo-generated charges generated in the first photosensitive region 102 and the third photosensitive region 302 can be read simultaneously from the second floating diffusion region 112, and then the photo-generated charges generated in the second photosensitive region 202 and the fourth photosensitive region 402 can be read simultaneously from the second floating diffusion region 112. In addition, the photo-generated charges generated in the first photosensitive region 102, the second photosensitive region 202, the third photosensitive region 302, and the fourth photosensitive region 402 can also be read simultaneously through the second floating diffusion region 112. Due to the increase in the number of photosensitive regions, the full well capacity of the floating diffusion region has been further improved. The operation of reading photo-generated charges from the third floating diffusion region 312, the fourth floating diffusion region 512, and the fifth floating diffusion region 712 can be the same as the reading operation of the second floating diffusion region 112, which will not be repeated here.

In some embodiments, the reading circuit can simultaneously read from multiple floating diffusion regions to achieve the merging of more photosensitive regions. For example, in the embodiment shown in Figure 15, the reading circuit can simultaneously read out the photo-generated charges in the second floating diffusion region 112 and the fourth floating diffusion region 512 during one reading period, and simultaneously read out the photo-generated charges in the third floating diffusion region 312 and the fifth floating diffusion region 712 during the next reading period, thus achieving the merging and demodulation of the first photosensitive region 102 to the eighth photosensitive region 802.

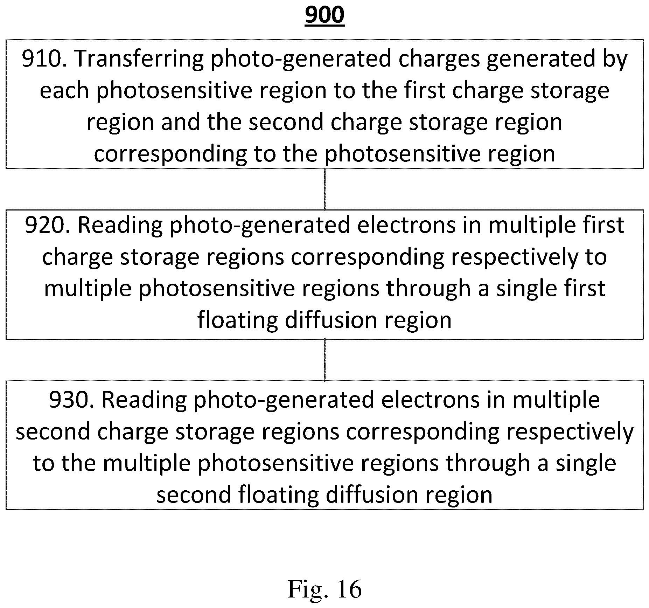

Figure 16 is a flowchart of a method 900 for demodulating a sensing unit in a time-of-flight image sensor according to an embodiment of the present application. Referring to Figure 16, the method 900 may comprise the following steps. In step 910, the photo-generated charges generated by each of the multiple photosensitive regions (102, 202) comprised in the sensing unit can be transferred to the first charge storage region (106, 206) and the second charge storage region (108, 208) corresponding to the photosensitive region in a time sequential manner. In step 920, the photo-generated electrons in multiple first charge storage regions (106, 206) corresponding respectively to the multiple photosensitive regions (102, 202) are read through a single first floating diffusion region (110). In step 930, the photo-generated electrons in multiple second charge storage regions (108, 208) corresponding respectively to the multiple photosensitive regions (102, 202) are read through a single second floating diffusion region (112).

Photo-generated electrons generated in different photosensitive regions can be synchronously transferred to the corresponding first or second floating diffusion region and simultaneously read out, or can be separately transferred to the corresponding first or second floating diffusion region and read out separately. For example, when different photosensitive regions are distributed in different rows of the sensing array, a row-by-row reading method can be adopted, wherein the same reading circuit and floating diffusion region is used to individually read the photo-generated electrons generated by each row of photosensitive regions row by row based on time; alternatively, it is possible to synchronously and simultaneously read out the photo-generated electrons generated by the photosensitive regions in different rows, thereby achieving the technical effect of pixel merging reading.

In addition, the reading circuit can read out the charges in a single floating diffusion region at the same time, or can read out the charges in multiple floating diffusion regions at the same time to further achieve the technical effect of pixel merging reading.

An embodiment of the present application also provides an image sensor, which comprises an array formed by the sensing units described above. In addition, the image sensor can also comprise a light source, a correlated double sampling module, a timing control circuit, and a reading circuit.

Although the present invention has been described here with reference to the explanatory embodiments, the above embodiments are only the preferred embodiments of the present invention, and the embodiments of the present invention are not limited by the above embodiments. It should be understood that those skilled in the art can design many other modifications and implementations, which will fall within the scope and spirit of the principles disclosed in this application.

## Claims

1. A sensing unit for a time-of-flight image sensor, comprising:
a first photosensitive region, comprising a pinned photodiode structure formed in a substrate to generate photo-generated charges, the substrate having a first doping type, the pinned photodiode structure comprising a first region having a second doping type and a second region being located above the first region and having the first doping type;
a first demodulation gate for transferring photo-generated charges in the first photosensitive region to a first charge storage region;
a second demodulation gate for transferring photo-generated charges in the first photosensitive region to a second charge storage region;
a first transfer gate for transferring photo-generated charges in the first charge storage region to a first floating diffusion region; and
a second transfer gate for transferring photo-generated charges in the second charge storage region to a second floating diffusion region.

2. The sensing unit of claim 1, further comprising:
a first storage gate located above the first charge storage region, for facilitating the transfer of photo-generated charges from the first photosensitive region to the first charge storage region; and
a second storage gate located above the second charge storage region, for facilitating the transfer of photo-generated charges from the first photosensitive region to the second charge storage region.

3. The sensing unit of claim 2, wherein:
the first demodulation gate is partially or entirely located above the first photosensitive region,
the first demodulation gate and the first storage gate being simultaneously applied with voltage to transfer photo-generated charges from the first photosensitive region to the first charge storage region; and
the second demodulation gate is partially or entirely located above the first photosensitive region,
the second demodulation gate and the second storage gate being simultaneously applied with voltage to transfer photo-generated charges from the first photosensitive region to the second charge storage region.

4. The sensing unit of claim 3, wherein a voltage applied on the first demodulation gate is less than a voltage applied on the first storage gate, and a voltage applied on the second demodulation gate is less than a voltage applied on the second storage gate.

5. The sensing unit of claim 1, wherein a portion of the substrate covered by the first demodulation gate protrudes into the first photosensitive region, such that the first photosensitive region at least partially surrounds the portion of the substrate covered by the first demodulation gate, and
a portion of the substrate covered by the second demodulation gate protrudes into the first photosensitive region, such that the first photosensitive region at least partially surrounds the portion of the substrate covered by the second demodulation gate.

6. The sensing unit of claim 1, wherein the first demodulation gate and the second demodulation gate are located on opposite sides, adjacent sides, diagonal sides, or a same side of the first photosensitive region.

7. The sensing unit of claim 1, wherein the first demodulation gate and the second demodulation gate are rectangular, semicircular, semi regular polygon, fan-shaped, L-shaped or V-shaped.

8. The sensing unit of claim 1, further comprising:
an intermediate demodulation gate located above the first photosensitive region and between the first demodulation gate and the second demodulation gate.

9. The sensing unit of claim 8, wherein:
when transferring photo-generated charges in the first photosensitive region to the first charge storage region, a voltage applied on the intermediate demodulation gate is less than a voltage applied on the first demodulation gate, and
when transferring the photo-generated charge in the first photosensitive region to the second charge storage region, a voltage applied on the intermediate demodulation gate is less than a voltage applied on the second demodulation gate.

10. The sensing unit of claim 9, wherein the intermediate demodulation gate has an H shape, and the first demodulation gate and the second demodulation gate are embedded in concave regions on opposite sides of the H shape, such that the intermediate demodulation gate surrounds a portion of the first demodulation gate and the second demodulation gate.

11. The sensing unit of claim 1, wherein the first demodulation gate extends to be above the first charge storage region, and the second demodulation gate extends to be above the second charge storage region.

12. The sensing unit of claim 1, wherein a doping concentration in the second region of the pinned photodiode structure is higher than that of the substrate.

13. The sensing unit of claim 1, further comprising:
a second photosensitive region having the pinned photodiode structure so as to generate photo-generated charges;
a third demodulation gate for transferring photo-generated charges in the second photosensitive region to a third charge storage region;
a fourth demodulation gate for transferring photo-generated charges in the second photosensitive region to a fourth charge storage region;
a third transfer gate for transferring photo-generated charges in the third charge storage region to the first floating diffusion region; and
a fourth transfer gate for transferring photo-generated charges in the fourth charge storage region to the second floating diffusion region.

14. The sensing unit of claim 13, further comprising:
a third photosensitive region having the pinned photodiode structure, so as to generate photo-generated charges;
a fifth demodulation gate for transferring photo-generated charges in the third photosensitive region to a fifth charge storage region;
a sixth demodulation gate for transferring photo-generated charges in the third photosensitive region to a sixth charge storage region;
a fifth transfer gate for transferring photo-generated charges in the fifth charge storage region to the second floating diffusion region;
a sixth transfer gate for transferring photo-generated charges in the sixth charge storage region to a third floating diffusion region;
a fourth photosensitive region having the pinned photodiode structure, so as to generate photo-generated charges;
a seventh demodulation gate for transferring photo-generated charges in the fourth photosensitive region to a seventh charge storage region;
an eighth demodulation gate for transferring photo-generated charges in the fourth photosensitive region to an eighth charge storage region;
a seventh transfer gate for transferring photo-generated charges in the seventh charge storage region to the second floating diffusion region; and
an eighth transfer gate for transferring photo-generated charges in the eighth charge storage region to the third floating diffusion region.

15. The sensing unit of claim 14, further comprising:
a first storage gate located above the first charge storage region for facilitating the transfer of photo-generated charges from the first photosensitive region to the first charge storage region;
a second storage gate located above the second charge storage region for facilitating the transfer of photo-generated charges from the first photosensitive region to the second charge storage region;
a third storage gate located above the third charge storage region for facilitating the transfer of photo-generated charges from the second photosensitive region to the third charge storage region;
a fourth storage gate located above the fourth charge storage region for facilitating the transfer of photo-generated charges from the second photosensitive region to the fourth charge storage region;
a fifth storage gate located above the fifth charge storage region for facilitating the transfer of photo-generated charges from the third photosensitive region to the fifth charge storage region;
a sixth storage gate located above the sixth charge storage region for facilitating the transfer of photo-generated charges from the third photosensitive region to the sixth charge storage region;
a seventh storage gate located above the seventh charge storage region for facilitating the transfer of photo-generated charges from the fourth photosensitive region to the seventh charge storage region; and
an eighth storage gate, located above the eighth charge storage region for facilitating the transfer of photo-generated charges from the fourth photosensitive region to the eighth charge storage region.

16. The sensing unit of claim 14, further comprising:
a first anti-blooming gate for transferring residual photo-generated charges in the first photosensitive region to a first power supply voltage terminal;
a second anti-blooming gate for transferring residual photo-generated charges in the second photosensitive region to the first power supply voltage terminal;
a third anti-blooming gate for transferring residual photo-generated charges in the third photosensitive region to a second power supply voltage terminal; and
a fourth anti-blooming gate for transferring residual photo-generated charges in the fourth photosensitive region to the second power supply voltage terminal.

17. A time-of-flight image sensor, comprising an array formed by multiple sensing units, wherein the sensing unit is the sensing unit according to any of claims 1 to 16.

18. A demodulation method for a sensing unit used in a time-of-flight image sensor, the sensing unit comprising multiple photosensitive regions, and the method comprising:
transferring photo-generated charges in each photosensitive region to a first charge storage region and a second charge storage region corresponding to the photosensitive region in a time sequential manner respectively;
reading photo-generated charges in multiple first charge storage regions corresponding to the multiple photosensitive regions through a single first floating diffusion region respectively; and
reading photo-generated charges in multiple second charge storage regions corresponding to the multiple photosensitive regions through a single second floating diffusion region respectively.

19. The method of claim 18, wherein photo-generated charges from different photosensitive regions are synchronously transferred to the corresponding first floating diffusion region or second floating diffusion region and simultaneously read out; or
the photo-generated charges from different photosensitive regions are separately transferred to the corresponding first or second floating diffusion regions and read out separately.

20. The method of claim 18, wherein the first floating diffusion regions in multiple sensing units are read simultaneously, and the second floating diffusion regions in multiple sensing units are read simultaneously, a time for reading the first floating diffusion regions being different from a time for reading the second floating diffusion regions.
